# EUROPEAN PATENT APPLICATION

(11) **EP 3 522 370 A1**
(43) Date of publication of application: **07.08.2019**
(21) Application number: 17854693.3
(22) Date of filing: 14.09.2017
(51) Int. Cl.: H02S 40/22, F24S 23/74

(54) **APPARATUS FOR COLLECTING AND TRANSMITTING SOLAR ENERGY, AND METHOD THEREFOR**

(30) Priority: 30.09.2016 CN 201610871699
(71) Applicant: Hangzhou Lingying Technology Co., Ltd, Hangzhou, Zhejiang 311199 (CN)
(72) Inventor: LI, Guohua, Hangzhou, Zhejiang 311199 (CN)
(74) Representative: AWA Sweden AB
(86) International application number: PCT/CN2017/101708
(87) International publication number: WO 2018/059243

(57) **Abstract**

The invention belongs to the field of solar energy collection and transmission technology and application, and particularly relates to a solar energy collection and transmission device, comprising a light-transmitting body, a transmission layer and a plurality of reflectors connected to each other, wherein the transmission layer is provided with a light collection port, The reflector includes an acquisition transmission plate surrounded by an arc AOAX, a straight line AOB, and a straight line BC. The AO end of the arc AOAX is sequentially connected to the AO end of the straight line AOB and the C end of the straight-line BC. The solar energy collection and transmission device proposed by the invention has a large collection range, can be directly utilized or transformed after collection, has high aggregation degree, small transmission loss, unrestricted shape and wide application range. The invention also discloses a principle of a solar energy collecting and transmitting device.

## Description

### COPYRIGHT STATEMENT

A portion of the disclosure of this patent application document contains material that is subject to copyright protection including the drawings. The copyright owner has no objection to the facsimile reproduction by anyone of the patent document or the patent disclosure as it appears in the Patent and Trademark Office file or records, but otherwise reserves all copyright rights whatsoever

### TECHNICAL FIELD

The invention relates to a solar energy collecting and conveying device and a principle thereof, which have large collection range, can be directly utilized or transformed after collection, have high aggregation degree, small transmission loss, unrestricted shape and wide application range. It belongs to solar energy collection and transmission technology and application fields.

### BACKGROUND

The development of solar energy utilization technology has enabled solar power generation technology and solar lighting technology to gradually enter people's field of vision. The difference in day and night, low solar density, difficulty in collecting, etc., resulting in high solar energy utilization costs, is the main factor hindering the widespread use of the sun.

At present, the solar energy utilization mainly includes solar illumination, and the optical fiber is collected. The diameter of the collected light is small, and it is not suitable for large-area collection; the lens is collected, the volume is large, and the shape is limited, the collection area is restricted, the diffused light cannot be used, and the transmission is difficult; Array; requires accurate sun tracking and positioning device, complicated mechanical structure, high cost, moving parts, repair problems, etc., can not use diffused light.

Solar heat utilization, vacuum tube energy density is not high, temperature can not be further improved, only suitable for small-scale heating; lens collection, bulky, limited by shape, collection area is restricted, transmission is difficult, can not use diffused light; solar reflective array Need precise sun tracking and positioning device, complicated mechanical structure, high cost, moving parts, repair problems, etc., can not use diffused light.

The efficiency of solar power generation and solar cells is low. The operating efficiency of monocrystalline silicon cells is less than 30%, the working efficiency of commercial use is not even 20%, the working range is limited by frequency bands, other parts are converted into heat energy, and cooling is caused. Problems, aging problems, high cost issues, etc.

In summary, in order to solve the problem of difficulty in collecting solar energy utilization technology in the prior art, and utilizing low efficiency, it is urgent to invent a large collection range, which can be directly utilized or converted after collection, with high aggregation degree and small transmission loss. The shape is not limited, and a wide range of solar energy collection and transmission devices and their principles are applicable.

### SUMMARY OF THE INVENTION

The invention provides a solar energy collection and transmission device and a principle thereof, which have large collection range, can be directly utilized or transformed after collection, have high aggregation degree, small transmission loss, unrestricted shape and wide application range. The invention solves the problems of collection of solar energy utilization technologies existing in the prior art, and utilization of low efficiency and the like.

In order to solve the above technical problem, the technical solution of the present invention is:
A solar energy collecting and conveying device comprises a light transmitting body, a conveying layer and a plurality of reflecting bodies, wherein the reflecting body is fixed by the light transmitting body, and a light collecting port is arranged in the conveying layer; the reflecting body comprises an arc AOAX, line AOB, line BC enclosed transmission board; AO end of arc AOAX is connected with AO end of line AOB and C end of line BC.

The central angle corresponding to the arc AO-AX is 0-90°, and the angle between the straight line AOB and the straight-line B-C is 0-180°. Preferably, the arc AO-AX corresponds to a central angle of 20 to 75°.

The reflector and the light transmissive body may be an integrally formed structure, and the inside of the reflector may be provided with a filling substance. The inside of the reflector can be filled with any substance, and when the reflector and the light-transmitting body are produced, the material of the reflector can be reduced, and other inexpensive materials can be used instead of the material, thereby reducing the cost.

The interior of the reflector may be provided with a filling substance, which is a solid, a gas or a vacuum. When the light transmitting body is a solid, the reflector is fixed on the light transmitting body; when the light transmitting body is a liquid, a gas or a vacuum, the reflecting body is fixed by a separate fixing device.

The light incident interface of the light transmissive body may be disposed in an inclined manner with an inclination angle of 0-90°. The light incident on the obliquely disposed light-transmitting body can change the oblique light into vertical light.

a first transmissive film may be disposed at a top end of the transparent body, a second transmissive film is disposed on an upper end surface of the transmissive layer; a first reflective film is coated around the reflective body, and an upper end surface and a bottom end surface of the upper end surface of the transport layer Provided with a second reflective film; the arc AOAX film extends into the upper end surface of the transport layer and is provided with a second reflective film, and the lower end surface is provided with a third transmissive film, which avoids back and forth reflection of light in the transport layer, resulting in loss The rate is improved.

The arc AOAX of all the reflectors is sequentially arranged in one direction on the light transmitting body.

The plurality of reflectors AOAX are sequentially arranged in one direction on the light-transmitting body to form a first collection group, and the plurality of reflectors AOAX are sequentially arranged in one direction on the light-transmitting body to form a second collection group; the first collection group The orientation of the middle arc AOAX is opposite to the orientation of the arc AOAX in the second collection group.

A principle of a solar energy collection and transmission device, comprising the following steps:
1) Construct a light vertical incidence model, define the light entering the light beam into the interface, and then vertically enter the circle O, A is the point on the circle O, OA is the horizontal line, and the vertical incident light a and the inner surface of the circle O The intersection point is AO, ∠AOAO=α, then: the intersection point A1 of the primary reflection line AOA1 and the arc, ∠AOA1=3α, the intersection point A2 of the secondary reflection line A1A2 and the arc, ∠AOA2=5α;
   It can be concluded that: ∠AOAn=(2n+1)α, where n is the number of times the light is reflected on the inner surface of the arc, and its value is 1, 2, 3...n;
2) Define the vertical light a+ into the circle O, the distance between the intersection of the incident light a+ and OA and the center of the circle O is X, the primary reflected light of the incident light a and a+ intersects at point B, and the arc AB distance in the area OBA The distance of the O arc decreases as X increases;
   It can be concluded that in the coordinate system with the center O as the origin, the point B uses the X expression: B=-2X2(1-X2)1/2;
   It can be concluded that the reflected light passes through the points in the area OBA and the circle OA region;
3) The intersection of the incident light a+ and OA is defined as Xx, and the primary reflected light of the incident light perpendicular to the Xx and XO intervals is surrounded by AOAxCB; the value of x in Xx is 1, 2, 3...x.

The invention has the following characteristics and beneficial effects:
The invention relates to a solar energy collection and transmission device and a principle collection range thereof, which can directly utilize or transform a collection point, or can be utilized or converted after long-distance transmission, can collect diffused light, can be applied to solar illumination, or can be light. Heat utilization can also generate electricity from solar cells. High degree of aggregation, small transmission loss, unrestricted shape, wide application range, can be used for solar energy utilization, can also be used for shading, outside the structure, wall and so on. The principle of a solar energy collection and transmission device is directed to a solar energy collection and transmission device, which solves the problem of the size setting of the reflector. The material of the reflector is cheaper than the material of the light-transmitting body, which can reduce the cost of the solar energy collection and transmission device and increase the economy. benefit.

### BRIEF DESCRIPTION OF THE DRAWINGS

In order to more clearly illustrate the embodiments of the present invention or the technical solutions in the prior art, the drawings used in the embodiments or the description of the prior art will be briefly described below. Obviously, the drawings in the following description are only It is a certain embodiment of the present invention, and other drawings can be obtained from those skilled in the art without any inventive labor.
1 is a schematic structural view of a solar energy collection and transmission device and a principle thereof according to the present invention;
2 is a schematic structural view of a solar energy collecting and transmitting device and a reflective body thereof according to the present invention;
3 is a schematic diagram 1 of a solar energy collection and transmission device and a principle thereof according to the present invention;
4 is a schematic diagram 2 of a solar energy collection and transmission device and a principle thereof according to the present invention;

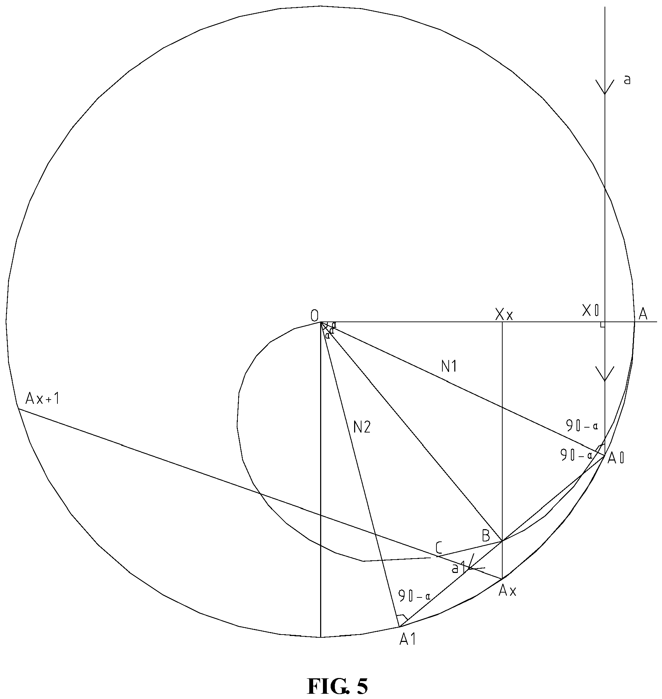

Figure 5 is a schematic diagram 3 of a solar energy collection and transmission device and its principle according to the present invention;
6 is a schematic diagram showing a unidirectional structure of a solar energy collecting and transmitting device and a principle thereof according to the present invention;
7 is a schematic diagram showing a multi-directional structure of a solar energy collecting and transmitting device and a principle thereof according to the present invention;
8 is a schematic view showing the structure of a surface auxiliary film of a light-transmitting body according to a solar energy collecting and transmitting device and a principle thereof;
9 is a schematic view showing a tilting structure of a surface of a light-transmitting body according to a solar energy collecting and transmitting device and a principle thereof;
10 is a unidirectional ray refraction diagram of a solar energy collection and transmission device and a principle thereof according to the present invention;
11 is a multi-directional light refraction diagram of a solar energy collection and transmission device and a principle thereof according to the present invention;
12 is a light refraction diagram of a surface coating of a light-transmitting body of a solar energy collecting and transmitting device and a principle thereof according to the present invention;

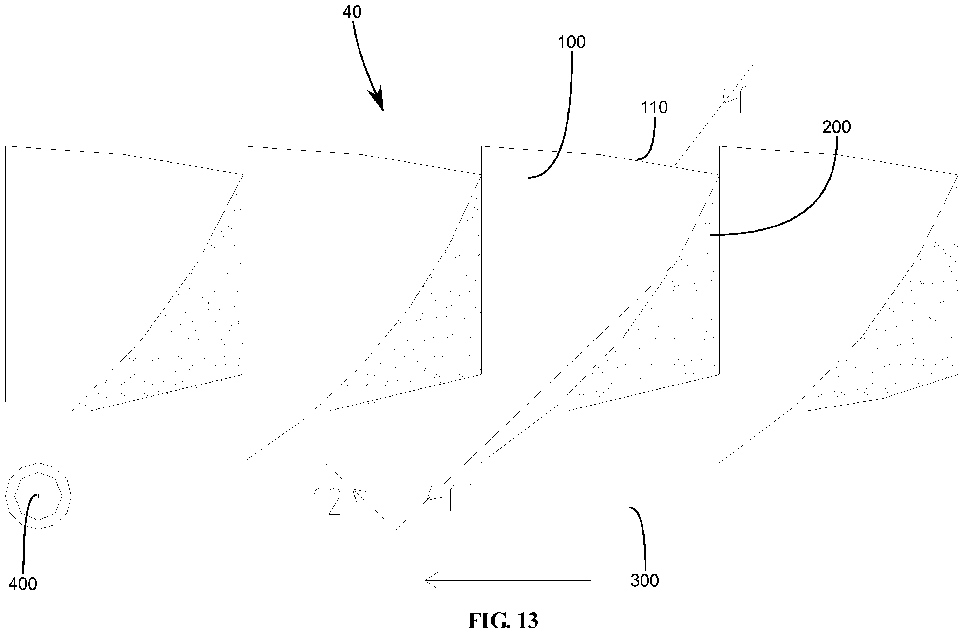

FIG. 13 is a perspective view of a tilted light refracting surface of a light-transmitting body of a solar energy collecting and transmitting device and a principle thereof according to the present invention.

In the figure, 1-light transmitting body; 2-reflecting body; 3-transporting layer; 4-light collecting port; 5-first transmitting film; 6-second transmitting film; 7-first reflecting film; Reflective film; 9-third transmission film.

### DETAILED DESCRIPTION

The specific embodiments of the present invention are further described below in conjunction with the accompanying drawings. It is to be noted that the description of the embodiments is intended to aid the understanding of the invention, but is not intended to limit the invention. Further, the technical features involved in the various embodiments of the present invention described below may be combined with each other as long as they do not constitute a conflict with each other.

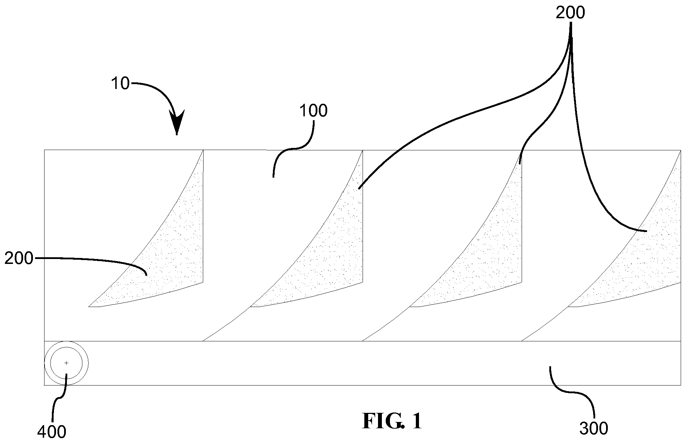

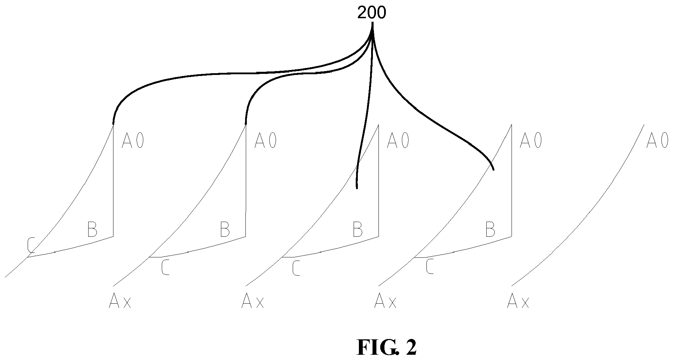

Referring to FIG. 1 and FIG. 2, a schematic diagram of a structure of a solar energy collecting and transmitting device and a principle thereof, and a structural diagram of a reflecting body. A solar energy collecting and transmitting device comprises a light-transmitting body 1, a transport layer 3 and a plurality of reflectors 2 connected to each other, and a light collecting port 4 is disposed in the transport layer 3; the reflector 2 includes an arc AOAX, a straight line AOB, the acquisition transmission board surrounded by the straight line BC; the AO end of the arc AOAX is sequentially connected with the AO end of the straight line AOB and the C end of the straight line BC. The central angle corresponding to the arc AOAX is 0-90°, and the angle between the straight line AOB and the straight line BC is 0-180°. Preferably, the arc AOAX corresponds to a central angle of 20 to 75°.

The reflector 2 and the light-transmitting body 1 may be an integrally formed structure, and the inside of the reflector 2 may be provided with a filling substance. The inside of the reflector 2 can be filled with any substance. When the reflector 2 and the light-transmitting body 1 are produced, the material of the reflector 2 can be reduced, and other inexpensive materials can be used instead of the material, thereby reducing the cost. The filling material is a solid, a gas or a vacuum, and the light transmitting body 1 may be a solid, a liquid, a gas or a vacuum. When the light-transmitting body 1 is a solid, the reflector 2 is fixed to the light-transmitting body 1; when the light-transmitting body 1 is a liquid, a gas or a vacuum, the reflector 2 is fixed by a separate fixing device.

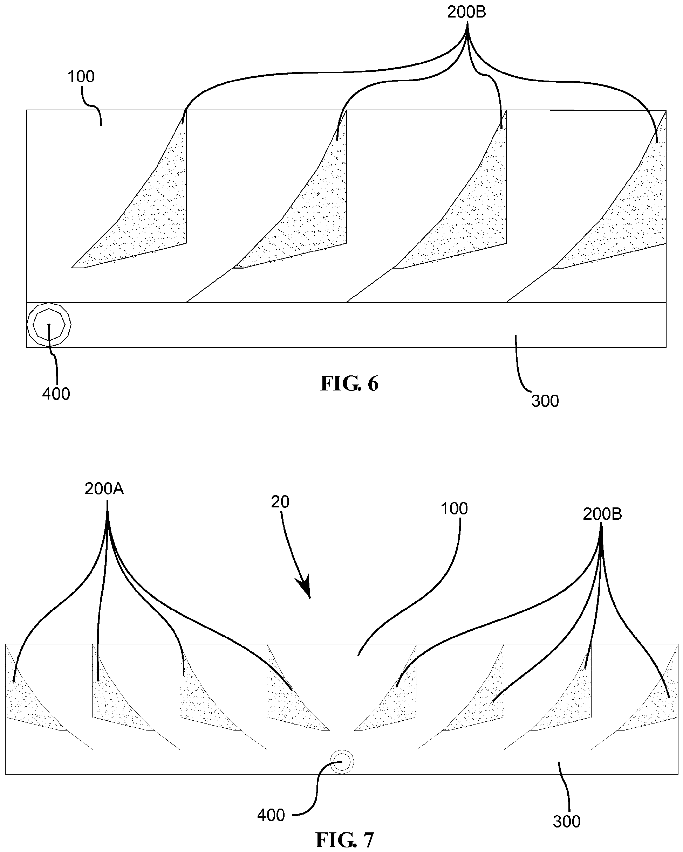

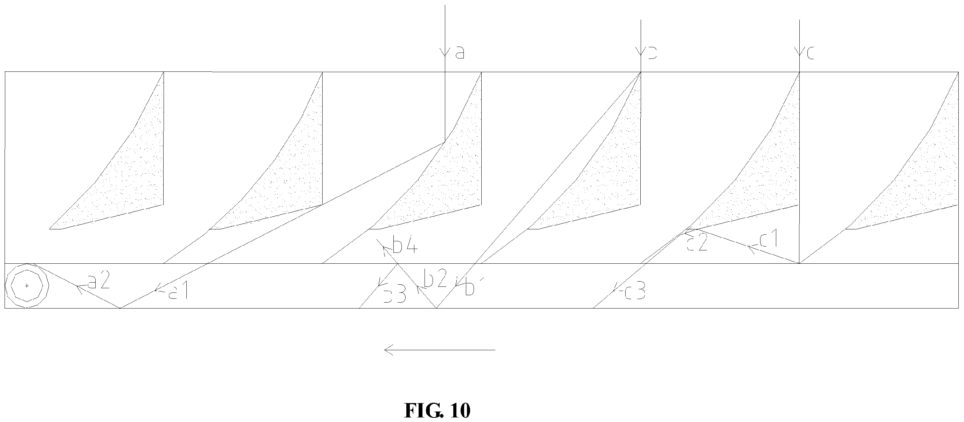

Referring to FIG. 6 and FIG. 10, a solar energy collection and transmission The unidirectional structure diagram of the device and its principle and the ray refraction map of the unidirectional reflector; the arcs AOAX of all the reflectors 2 are sequentially arranged in one direction on the light-transmitting body 1.

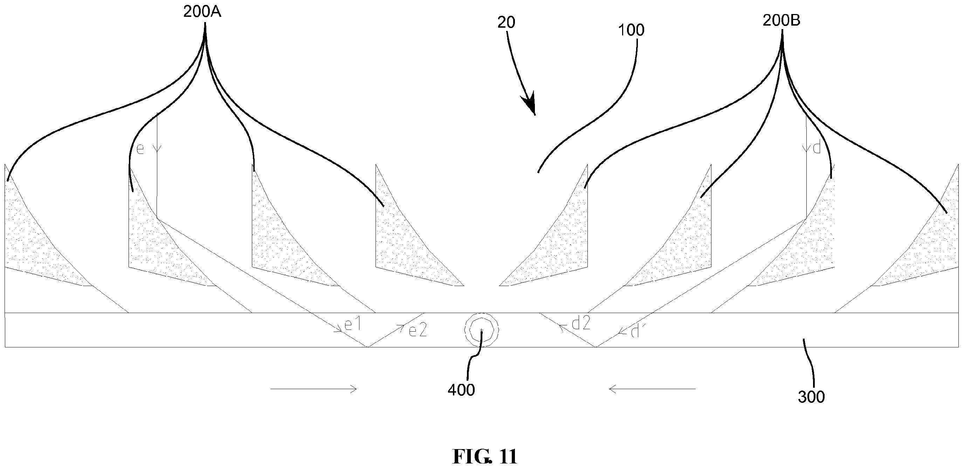

In other embodiments, reference is made to the two-way structure diagram of the solar energy collecting and transmitting device and the principle thereof shown in FIG. 7 and FIG. 11 and the light refraction pattern of the bidirectional reflector; the arc AOAX of the plurality of reflectors 2 One direction is sequentially arranged on the light-transmitting body 1 to form a first collection group, and the arcs AOAX of the plurality of reflectors 2 are sequentially arranged in one direction on the light-transmitting body 1 to form a second collection group; the orientation of the arc AOAX in the first collection group It is opposite to the orientation of the arc AOAX in the second collection group. The settings of the second collection group and the first collection group provide light collection efficiency.

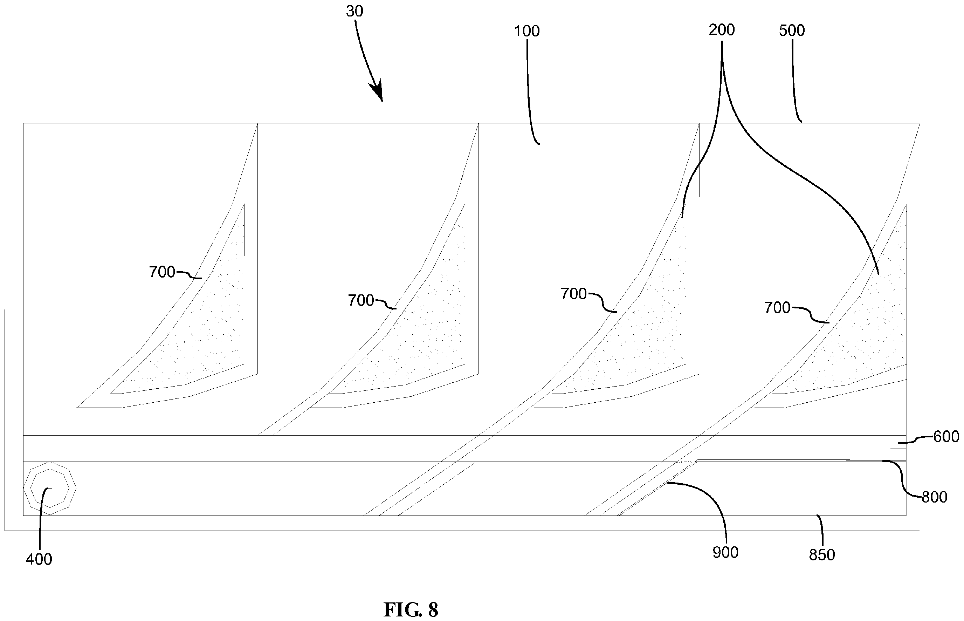

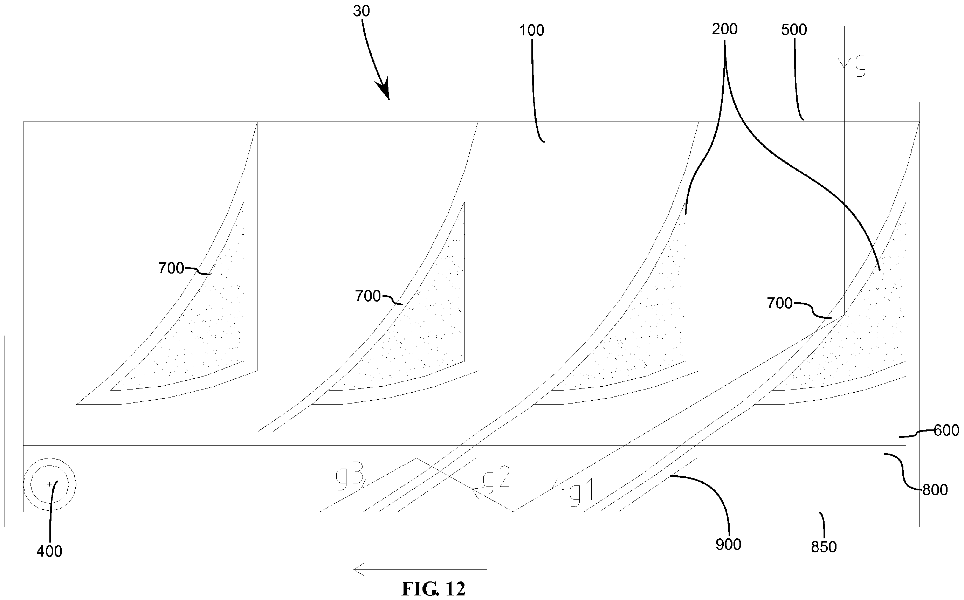

In other embodiments, a schematic diagram of a surface structure of a light-transmissive body of a solar energy collecting and transmitting device and a principle thereof as shown in FIG. 8 and FIG. 12 and a light-refraction diagram of a surface-reflecting body of a light-transmitting body; a first transmissive film 5 is disposed at a top end of the light transmissive body 1 , and a second transmissive film 6 is disposed on an upper end surface of the transmissive layer 3 . The reflective body 2 is surrounded by a first reflective film 7 , and the transfer layer 3 is The bottom surface of the upper end surface and the bottom end surface are provided with a second reflective film 8; the upper surface of the arc AOAX film extending into the transport layer 3 is provided with a second reflective film 8, and the lower end surface is provided with a third transmissive film 9, first transmission The arrangement of the film 5 and the second transmission film 6 reduces the transmission loss rate when light enters the light-transmitting body 2, and the arrangement of the first reflection film 7 and the second reflection film 8 avoids back-reflection of light rays in the transmission layer 3, resulting in Increased light loss rate.

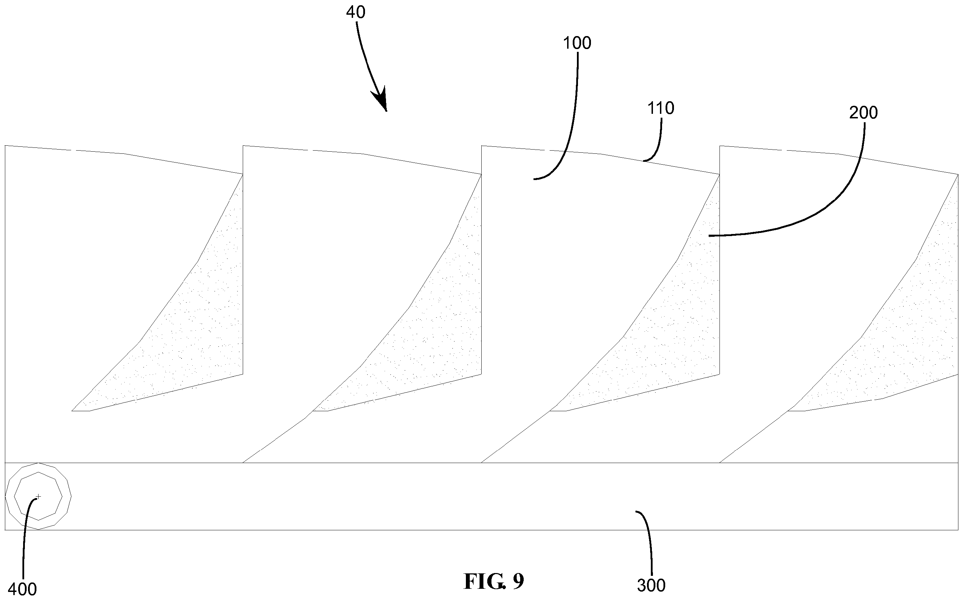

In other embodiments, reference is made to the solar energy collecting and transmitting device shown in FIG. 9 and FIG. 13 and the schematic diagram of the inclined structure of the surface of the light transmitting body and the oblique light refracting pattern of the surface of the light transmitting body; The light injection interface of 2 can be set to be inclined, and the inclination angle is 0-90°. The light incident on the obliquely disposed light-transmitting body 2 can change the oblique light into vertical light.

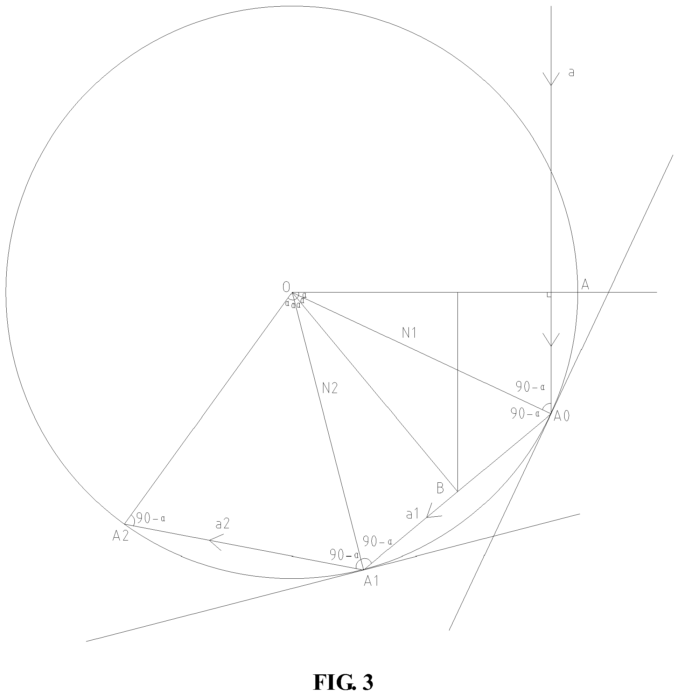

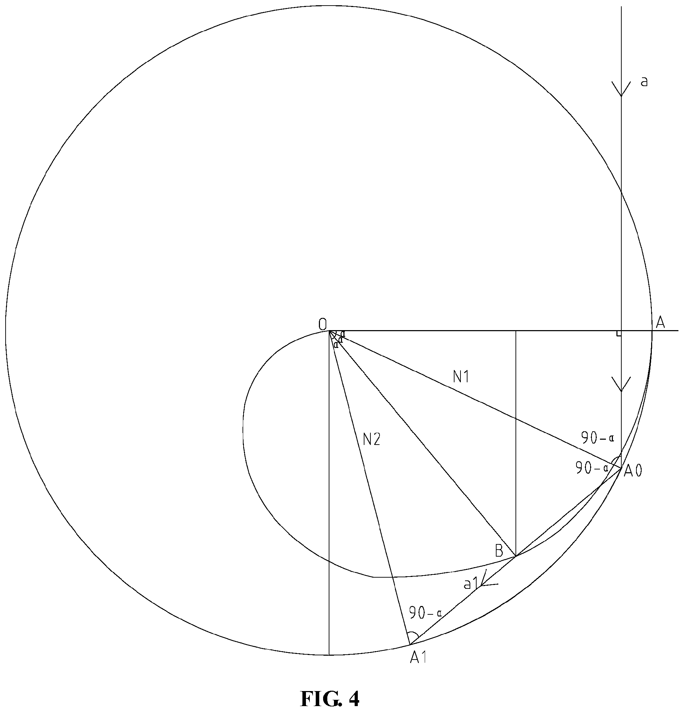

Referring to FIG. 3, FIG. 4 and FIG. 5, a schematic diagram of a solar energy collection and transmission device and a principle thereof. A principle of a solar energy collection and transmission device, comprising the following steps:
1) Construct a light vertical incidence model, define the light entering the light-transmitting body 2 into the interface, and then vertically enter the circle O, A is the point on the circle O, OA is the horizontal line, and the vertical incident light a and the circle O The surface intersection point is AO, ∠AOAO=α, then: the intersection point A1 of the primary reflection line AOA1 and the arc, ∠AOA1=3α, the intersection point A2 of the secondary reflection line A1A2 and the arc, ∠AOA2=5α;
   It can be concluded that: ∠AOAn=(2n+1)α, where n is the number of times the light is reflected on the inner surface of the arc, and its value is 1, 2, 3...n;
3) Define the vertical light a+ into the circle O, the distance between the intersection of the incident light a+ and OA and the center of the circle O is X, the primary reflected light of the incident light a and a+ intersects at point B, and the arc AB distance in the area OBA The distance of the O arc decreases as X increases;
   It can be concluded that in the coordinate system with the center O as the origin, the point B uses the X expression: B=-2X2(1-X2)1/2;
   It can be concluded that the reflected light passes through the points in the area OBA and the circle OA region;
3) The intersection of the incident light a+ and OA is defined as Xx, and the primary reflected light of the incident light perpendicular to the Xx and XO intervals is surrounded by AOAxCB; the value of x in Xx is 1, 2, 3...x.

The invention relates to a solar energy collection and transmission device and a principle collection range thereof, which can directly utilize or transform a collection point, or can be utilized or converted after long-distance transmission, can collect diffused light, can be applied to solar illumination, or can be light. Heat utilization can also generate electricity from solar cells. High degree of aggregation, low transmission loss, unrestricted shape, wide application range, can be used for solar energy utilization, and can also be used for visors, structural external surfaces, walls and so on.

The embodiments of the present invention have been described in detail above with reference to the drawings, but the invention is not limited to the described embodiments. It will be apparent to those skilled in the art that various changes, modifications, substitutions and variations of the embodiments are possible without departing from the spirit and scope of the invention.

## Claims

1. A solar energy collecting and transmitting device, comprising: a light-transmitting body,
a transport layer and a plurality of light-reflecting bodies connected to each other,
wherein the light-transporting port is disposed in the transport layer, the light-reflecting body comprises an arc AOAX, a straight line AOB, the acquisition transmission board surrounded by the straight line BC, the AO end of the arc AOAX is sequentially connected with the AO end of the straight line AOB and the C end of the straight line BC.

2. The solar energy collecting and transmitting device according to claim 1, wherein the arc AOAX corresponds to a central angle of 0 to 90°, and the angle between the straight line AOB and the straight line BC is 0 ∼180°.

3. A solar energy collection and transmission device according to claim 2, wherein the arc AOAX corresponds to a central angle of 20 to 75 degrees.

4. The solar energy collection and transmission device according to claim 1, wherein the reflector and the light transmissive body are integrally formed, and the interior of the reflector may be provided with a filling material, and the filling The substance is a solid, a gas or a vacuum, and the light transmitting body may be a solid, a liquid, a gas or a vacuum.

5. The solar energy collecting and conveying device according to claim 4, wherein when the light transmitting body is solid, the reflecting body is fixed on the light transmitting body; the light transmitting body is liquid in the case of gas or vacuum, the reflector is separately fixed by means of a fixing device.

6. The solar energy collecting and transmitting device according to claim 1 or 2 or 3 or 4, wherein the light incident interface of the light transmissive body is set to be inclined, and the tilt angle is 0-90°.

7. The solar energy collection and transmission device according to claim 1 or 2 or 3 or 4, wherein the top end of the light transmissive body is provided with a first transmissive film, and the upper end surface of the transport layer is provided with a second a transmissive film; the reflective body is surrounded by a first reflective film, and the upper end surface and the bottom end surface of the transport layer are provided with a second reflective film; and the arc AOAX film extends into the upper end surface of the transport layer The second reflective film is provided with a third transmissive film on the lower end surface.

8. A solar energy collecting and conveying device according to claim 1 or 2 or 3 or 4,
wherein all of the reflectors have an arc AOAX arranged in sequence in one direction on the light transmitting body.

9. The solar energy collection and transmission device according to claim 1 or 2 or 3 or 4, wherein the plurality of reflectors AOAX are sequentially arranged in one direction on the light-transmitting body to form a first collection group. The arcs AOAX of the plurality of reflectors are sequentially arranged in one direction on the light-transmitting body to form a second collection group; the orientation of the arc AOAX in the first collection group is opposite to the orientation of the arc AOAX in the second collection group.

10. A principle of a solar energy collection and transmission device according to any of claims 1-9, comprising the steps of:
constructing a light vertical incidence model, define the light a into the light-transmitting body into the interface, and then vertically enter the circle O, A is the point on the circle O, OA is the horizontal line, the vertical incident light a and the circle O The intersection of the inner surface is AO, ∠AOAO=α, then: the intersection A1 of the primary reflection line AOA1 and the arc, ∠AOA1=3α, the intersection A2 of the secondary reflection line A1A2 and the arc, ∠AOA2=5α, wherein n is the number of times the light is reflected on the inner surface of the arc;
it can be concluded that: ∠AOAn=(2n+1)α, where n is the number of times the light is reflected on the inner surface of the arc, and its value is 1, 2, 3...n;
define the vertical light a+ into the circle O, the distance between the intersection of the incident light a+ and OA and the center of the circle O is X, the primary reflected light of the incident light a and a+ intersects at point B, and the arc AB distance in the area OBA The distance of the O arc decreases as X increases;
it can be concluded that in the coordinate system with the center O as the origin, the point B uses the X expression: B=-2X2(1-X2)1/2;
it can be concluded that the reflected light passes through the points in the area OBA and the circle OA region;
3) The intersection of the incident light a+ and OA is defined as Xx, and the primary reflected light of the incident light perpendicular to the Xx and XO intervals is surrounded by AOAxCB;
the value of x in Xx is 1, 2, 3...x.
